# EUROPEAN PATENT SPECIFICATION

(11) **EP 3 832 737 B1**
(45) Date of publication and mention of the grant of the patent: **04.09.2024**
(21) Application number: 21150107.7
(22) Date of filing: 02.07.2012
(51) Int. Cl.: H01L 31/0224, H01L 31/072, H01L 31/0747

(54) **METHOD OF MANUFACTURING A HETERO-JUNCTION SOLAR CELL**
VERFAHREN ZUR HERSTELLUNG EINER HETEROÜBERGANGS-SOLARZELLE
PROCÉDÉ DE FABRICATION D'UNE CELLULE SOLAIRE À HÉTÉROJONCTION

(43) Date of publication of application: 09.06.2021
(62) Divisional of application: 12004905.1
(73) Proprietor: Meyer Burger (Germany) GmbH, 09337 Hohenstein-Ernstthal (DE)
(72) Inventor: Papet, Pierre, 2068 Hauterive (CH); Lachenal, Damien, 2022 Bevaix (CH)
(74) Representative: Steiniger, Carmen

(56) References cited:
- EP-A1- 1 555 695
- EP-A1- 1 696 492
- EP-A2- 1 881 534
- WO-A1-2012/059878
- JP-A- 2001 044 461
- JP-A- 2004 228 281
- JP-A- 2006 222 469
- GREEN M A: "Crystalline and thin-film silicon solar cells: state of the art and future potential", SOLAR ENERGY, PERGAMON PRESS. OXFORD, GB, vol. 74, no. 3, 1 March 2003 (2003-03-01), pages 181 - 192, XP004439139, ISSN: 0038-092X, DOI: 10.1016/S0038-092X(03)00187-7

## Description

The present invention relates to a method of manufacturing a hetero-junction solar cell, the solar cell having a front side for an incidence of light into the solar cell and a back side opposite to the front side. The method includes the steps of: providing a doped and textured semiconductor substrate, said semiconductor substrate having a front surface and a back surface opposite to each other and an edge surrounding the semiconductor substrate; forming at least one front layer on the front surface of the semiconductor substrate, wherein the at least one front layer covers at least a part of the edge of the semiconductor substrate, said at least one front layer containing semiconductor atoms or molecules being arranged in amorphous and/or microcrystalline and/or oxide and/or carbide phase, wherein said at least one front layer forms an emitter or a front surface field of the solar cell; forming at least one back layer on the back surface of the semiconductor substrate, said at least one back layer containing semiconductor atoms or molecules being arranged in amorphous and/or microcrystalline and/or oxide and/or carbide phase, wherein said at least one back layer forms a back surface field or a back emitter of the solar cell, and wherein the at least one front layer is formed prior to forming of the at least one back layer, and the at least one back layer covers at least a part of the edge of the semiconductor substrate and also covers at least a part of the at least one front layer that overlaps the edge of the semiconductor substrate; forming an electrically conductive anti-reflection coating on the at least one front layer, said anti-reflection coating covering the whole surface of the at least one front layer and being at least partially transparent to the light irradiating into the solar cell, wherein the anti-reflection coating covers at least a part of the at least one back layer overlapping the edge; forming an electrically conductive back coating on the at least one back layer; and forming a front grid metallization on the anti-reflection coating, wherein the conductive back coating is formed on the surface of the at least one back layer with a distance to the edge of the semiconductor substrate, leaving a merging region consisting of a margin area of the surface of the at least one back layer and the edge of the semiconductor substrate free from the conductive back coating, wherein there is no electrical contact between the conductive back coating and the conductive anti-reflection coating at all during the whole process of formation of the conductive back coating.

Methods and accordant hetero-junction solar cells with of that type are known in different variants in the state of the art. Conventional hetero-junction solar cells are formed from an n-type doped substrate wherein a p-type doped emitter is formed on a front side of this substrate. That front side corresponds to the face where sun light mainly introduces into the solar cell. Fabrication of this type of solar cell involves deposition of the p-doped emitter layer on the front side of the substrate and deposition of an n-doped layer forming a back surface field on the back side of the substrate. In other solar cells, the type of doping used for the substrate and the doped layers can be the opposite way round. Moreover, it is also possible to place the emitter on the back side of the substrate and to form a front surface field layer on the front side of the substrate.

To improve cell performances, intrinsic layers can be used between the substrate and the doped layers. The doped and intrinsic layers can be of any type of material. Most commonly, these layers are based on silicon in an amorphous and/or microcrystalline and/or oxide and/or carbide phase.

In hetero-junction solar cells, it is necessary to prevent an electrical short circuit between the electrically conductive layers on the front and on the back side of the solar cell. Since such an undesired short circuit is typically formed around the edges, that means the side surfaces, of the semiconductor substrate used, the methods for preventing such short circuits are referred to as edge isolation methods. In the state of the art, there are different technologies knows to provide an edge isolation of hetero-junction solar cells.

The document US 5,935,344 A describes a method for edge isolation of hetero-junction solar cells using a structuring of the electrical conductive films on the front side or on the back side of the solar cell by laser drilling. In result of this structuring, a trench is formed at a peripheral portion of the front side or of the back side of the solar cell, the trench going at least through the respective transparent conductive film and the respective doped amorphous silicon layer. The trench surrounds continuously the laminated body of electrical conductive layers formed on the front side or on the back side of the solar cell. Alternatively, the document suggests to remove all deposited layers at the side surfaces of the substrate or to expose the side surfaces of the substrate at least partially by forming a continuous trench around the side surfaces of the substrate by laser irradiation. This technology includes the risk of creation of damages of the certain substrate regions and layers of the solar cell by the impact of the laser. Structuring of the front transparent conductive film, as it is suggested in one embodiment of this document, leads, moreover, to a decreased cell performance.

Another method of edge isolation of solar cells is disclosed in the document WO 2012/059878 A1. During manufacturing of the proposed solar cell, a narrow line of coating is applied along cell edge on one side or on both sides or on the edge of the solar cell prior to depositing electrically conductive films on the front and/or the back side of the solar cell. After the deposition of the conductive films, the narrow line of coating is removed by a wet or dry processing step. Thus, an interruption of the electrical conductive layers on the front and/or the back side of the solar cell can be realized for preventing of short circuits between the front and the back side of the solar cell. Although this method is very effective, it requires first a very sensible, local formation of the thin, narrow line at the edge of the substrate which is not easy to handle and second a removal of that narrow line being under the conductive film bearing the risk of an unintentional removal of further, alongside parts of the conductive film.

The document JP 2006 222469 A describes a solar cell having on the front side and on the back side transparent, electrically conductive films, respectively, which are deposited on early identical areas, with a distance to the edge of the substrate in order to prevent short circuits between these films.

It is therefore the object of the present invention to provide an easy and low-cost method of manufacturing of a hetero-junction solar cell and an according solar cell, wherein short circuits between the front and the back side of the solar cell are prevented and the solar cell is not damaged by the method steps and shows good cell performance.

This object is solved by a method of the above mentioned type, wherein said electrically conductive anti-reflection coating covers the whole surface of the at least one front layer and said electrically conductive anti-reflection coating covers at least a part of the edge of the semiconductor substrate..

In the method of the present invention, already during the one step of forming the electrically conductive back coating all requirements for a prevention of short circuits between the front and the back side of the solar cell are fulfilled. By forming the electrically conductive back coating only in a middle part of the substrate leaving a margin to the edge of the substrate free, the conductive back coating does neither cover nor overlap over the side surfaces of the substrate and comes therefore not in contact with a conductive layer on the front side of the solar cell. The method of the present invention uses for this effect conventional process steps, like a deposition through a mask, which have no damaging influence on the solar cell substrate or its layers. The edge isolation method of the present invention can be easily implemented in the solar cell process flow without extra cost. Thus, an easy and low-cost but very reliable and effective method for edge isolation of hetero-junction solar cells can be provided by the present invention.

The method of the present invention involves no structuring of the transparent conductive layer(s) on front of the solar cell. Without this front side structuring, the cell front area is larger and allows collecting more light and generating more current. Moreover, the uniform front transparent conductive film (anti-reflection coating) provides a better cell appearance for module integration.

The edge isolation method of the present invention is only effective if the cell fabrication steps used are realized in a defined order. It is in particular advantageous if the at least one front layer is formed prior to forming of the at least one back layer. This sequence is not usual. If the formation of the at least one back layer would be performed before the formation of the at least one front layer, there would be a high risk of shunts on the cell edge.

In a variant of the method of the present invention, the conductive back coating is formed with a distance of 5 µm to 10 mm from the edge of the semiconductor substrate.

In a further improved embodiment of the present invention, the conductive back coating is formed with a distance of 30 µm to 3 mm from the edge of the semiconductor substrate.

It is especially beneficial if the conductive back coating is deposited on the surface of the at least one back layer through a shadow mask having a opening being adapted to the dimensions of the semiconductor substrate, but smaller, and having a cover region around this opening covering at least the margin area of the surface of the at least one back layer during deposition. The physical mask covers this way the substrate's edge during the deposition of the conductive back coating. The mask is, for instance, able to protect few micrometers to millimeters to the cell edge from the film deposition. The mask can be easily integrated in a carrier holder of a deposition tool. With this method, edge isolation can be performed during the back side conductive film deposition without the need of an extra step to perform the edge isolation. This leads to a reduction of process steps reducing the final cell costs.

In accordance with another option of the present invention, the conductive back coating is deposited on the whole surface of the at least one back layer, followed by a removal of a rim of the conductive back coating.

The removal of the rim of the conductive back coating can be done by chemical etching and/or lift-off and/or laser ablation of the rim of the conductive back coating.

By the method a hetero-junction solar cell with a front side for an incidence of light into the solar cell and a back side opposite to the front side is produced, the solar cell comprising: a doped and textured semiconductor substrate, said semiconductor substrate having a front surface and a back surface opposite to each other and an edge surrounding the semiconductor substrate; at least one front layer formed on the front surface of the semiconductor substrate, said at least one front layer containing semiconductor atoms or molecules being arranged in amorphous and/or microcrystalline and/or oxide and/or carbide phase; at least one back layer formed on the back surface of the semiconductor substrate, said at least one back layer containing semiconductor atoms or molecules being arranged in amorphous and/or microcrystalline and/or oxide and/or carbide phase; an electrically conductive anti-reflection coating formed on the at least one front layer, said anti-reflection coating covering the whole surface of the at least one front layer and being at least partially transparent to the light irradiating into the solar cell; an electrically conductive back coating formed on the at least one back layer; a front grid metallization formed on the anti-reflection coating; and a back electrode formed on the conductive back coating; wherein the conductive back coating is formed on the surface of the at least one back layer with a distance to the edge of the semiconductor substrate, leaving a merging region consisting of a margin area of the surface of the at least one back layer and the edge of the semiconductor substrate free from the conductive back coating, wherein there is no electrical contact between the conductive back coating and the conductive anti-reflection coating at all.

The hetero-junction solar cell can be produced without structuring of the front transparent conductive film forming the anti-reflection coating of the solar cell. This allows better light collection and cell performances with a homogeneous front side appearance of the solar cell having no color gradient of the anti-reflection coating on the edge of the solar cell.

In a favorable embodiment of the hetero-junction solar cell, the at least one back layer overlaps the at least one front layer. That leads to the effect that there is formed a horizontal structure of an n-/p-/n- or a p-/n-/p-layer-stack on the cell edge acting as two diodes in opposition that block current flow in lateral direction.

Exemplarily, the conductive back coating has a distance of 5 µm to 10 mm from the edge of the semiconductor substrate. This results in a very sure electrical isolation of the front side and the back side of the hetero-junction solar cell of the present invention.

A favorable embodiment of the method of the present invention is explained in the following with reference to the drawings in which
- Fig. 1: schematically shows a semiconductor substrate used for manufacturing a hetero-junction solar cell in accordance with the present invention in a sectional view;
- Fig. 2: schematically shows the substrate of Fig. 1 being covered by at least one front layer on a front surface of the semiconductor substrate;
- Fig. 3: schematically shows the structure of Fig. 2 being covered by at least one back layer on a back surface of the semiconductor substrate;
- Fig. 4: schematically shows the structure of Fig. 3 being coated by an electrically conductive anti-reflection coating formed on the at least one front layer;
- Fig. 5: schematically shows the structure of Fig. 4 wherein an electrically conductive back coating is deposited through a mask on the at least one back layer;
- Fig. 6: schematically shows the structure of Fig. 5 with removed mask;
- Fig. 7: schematically shows a hetero-junction solar cell being formed from the structure of Fig. 6 plus forming a front grid metallization and a back electrode;
- Fig. 8: corresponds to Fig. 7 with added charges illustrating the charge distribution at the front side, on the back side and on the edge of the hetero-junction solar cell; and
- Fig. 9: schematically shows the stack of layers present on the edge of the heterojunction solar cell of Fig. 8.

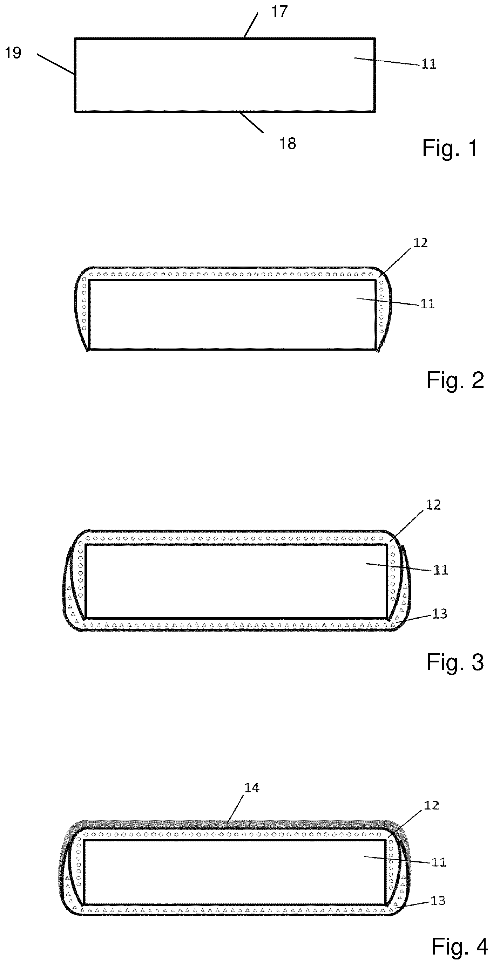

Figs. 1 to 7 schematically show an advantageous sequence of process steps of the method of the present invention resulting in a hetero-junction solar cell 1. The steps shown in the Figs. 1 to 7 are only representative figures showing characteristic but not all details of the process used.

As shown in Fig. 1, the method of the present invention starts with a semiconductor substrate 11. The semiconductor substrate 11 can consist of any semiconductive material that can have any size and doping. The semiconductor substrate 11 is in the embodiment shown of a crystalline semiconductor material, preferably of monocrystalline or multi-crystalline silicon. The semiconductor substrate 11 is doped. The doping can be of n-type or of p-type, dependent from the kind of solar cell to be produced. The semiconductor substrate 11 has a front surface 17 for an incidence of most of the light and a back surface 18 opposite to the front surface 17. The front surface 17 of the semiconductor substrate 11 is textured to decrease a reflection of light received. Moreover, the semiconductor substrate 11 has an edge 19 surrounding the bulk of the semiconductor substrate 11 and extending between the front surface 17 and the back surface 18 of the semiconductor substrate 11. The edge 19 is only schematically shown and is not necessarily flat as shown in Fig. 1, but can also be convex or pointed. As usual in semiconductor technologies, the semiconductor substrate 11 is cleaned. Cleaning steps are made before and/or after the following method steps, too, and are not especially mentioned in each case.

With reference to Fig. 2, in a next step of the method of the present invention, at least one front layer 12 is formed on the front surface 17 of the semiconductor substrate 11. The at least one front layer 12 can be one layer or a stack of layers. The at least one front layer 12 covers at least a part of the edge 19 of the semiconductor substrate 11. The at least one front layer 12 contains semiconductor atoms or molecules being arranged in amorphous and/or microcrystalline and/or oxide and/or carbide phase. For instance, the at least one front layer 12 can consist of an intrinsic silicon layer formed directly on the front surface 17 of the semiconductor substrate 11 and a doped amorphous silicon layer, such as a p-doped amorphous silicon layer, formed on the intrinsic layer. In other embodiments of the invention, that intrinsic layer can be omitted. The at least one front layer 12 is preferably deposited by PECVD (plasma enhanced physical vapor deposition). The at least one front layer 12 has typically a thickness of less than 50 nm. Depending on the type of solar cell to be produced, the at least one front layer 12 will form an emitter or a front surface field of the solar cell.

As demonstrated in Fig. 3, in a further step of the method of the present invention, at least one back layer 13 is formed on the back surface 18 of the semiconductor substrate 11. In the shown embodiment of the method of the present invention, the at least one back layer 13 is explicitly formed after the formation of the at least one front layer 12. The at least one back layer 13 can be one layer or a stack of layers. The at least one back layer 13 is preferably deposited by PECVD (plasma enhanced physical vapor deposition). The at least one back layer 13 has typically a thickness of less than 50 nm. The at least one back layer 13 covers at least a part of the edge 19 of the semiconductor substrate 11 and also covers at least a part of the at least one front layer 12 that overlaps the edge 19 of the semiconductor substrate 11.

The at least one back layer 13 contains semiconductor atoms or molecules being arranged in amorphous and/or microcrystalline and/or oxide and/or carbide phase. For instance, the at least one back layer 13 can consist of an intrinsic silicon layer formed directly on the back surface 18 of the semiconductor substrate 11 and a doped amorphous silicon layer, such as an n⁺-doped amorphous silicon layer, formed on the intrinsic layer. In other embodiments of the invention, that intrinsic layer can be omitted. Depending on the type of solar cell to be produced, the at least one back layer 13 will form a back surface field or a back emitter.

In the method step shown in Fig. 4, an electrically conductive anti-reflection coating 14 is formed on the at least one front layer 12. The anti-reflection coating 14 is at least partially transparent to the light irradiating into the solar cell. For instance, many transparent conductive oxides, such as indium oxide or indium tin oxide, can be used as material for the anti-reflection coating 14. The anti-reflection coating 14 covers at least the whole surface of the at least one front layer 12. The anti-reflection coating 14 also covers at least a part of the edge 19 of the semiconductor substrate 11 and at least a part of the at least one back layer 13 overlapping the edge 19 and at least a part of the at least one front layer 12 overlapping the edge 19.

Since, as mentioned above, the edge 19 of the semiconductor substrate 11 can be covered with a variable combination of layers being part of the at least one front layer 12 and/or the at least one back layer 13 and/or the anti-reflection coating 14, in the following as well as in the claims the expression "edge 19" should be understood as to be the whole surrounding side surface(s) of the semiconductor substrate 11 with and/or without these additional layers or parts of layers.

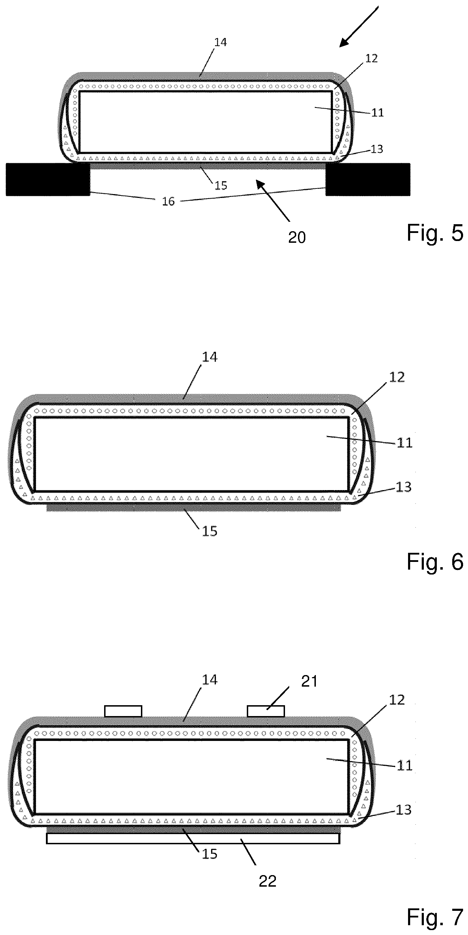

In a next step of the method of the present invention shown in Fig. 5, a mask 16 is provided on the back side of the structure. The mask 16 is a shadow mask has a cover region that covers the edge 19 of the semiconductor substrate 11 as well as a margin of the at least one back layer 13. In its middle region, the mask has an opening 20. The shape of the opening 20 is adapted to the shape of the semiconductor substrate 11, but has smaller dimensions. The margin can, for instance, have a radial dimension of a few micrometers to a few millimeters, such as of about 5 µm to about 10 mm, preferably of about 30 µm to 3 mm, measured from the edge 19 of the semiconductor substrate 11. Through the opening 20 of the mask 16, an electrically conductive back coating 15 is deposited on the surface of the at least one back layer 13. Due to the mask 16, the electrically conductive back coating 15 is formed only on the surface of the at least one back layer 13 with a distance to the edge 19 of the semiconductor substrate 11, leaving a merging region consisting of a margin area of the surface of the at least one back layer 13 and the edge 19 of the semiconductor substrate 11 free from the conductive back coating 15. There is no electrical contact between the conductive back coating 15 and the conductive anti-reflection coating 14 at all during the whole process of formation of the conductive back coating 15. The area covered by the conductive back coating 15 should be maximized without being in contact with the anti-reflection coating 14.

The anti-reflection coating 14 and the conductive back coating 15 can be deposited in any order or at the same time.

The conductive back coating 15 can be formed by transparent conductive film(s) and/or metallic film(s). The conductive back coating 15 film(s) can be deposited by sputtering or evaporation techniques.

In other embodiments of the present invention, the step of Fig. 5 can be replaced by two sub-steps wherein in a first sub-step the conductive back coating 15 is deposited on the surface of the at least one back layer 13. During deposition of the conductive back-coating 15, an electrical contact between the conductive back coating 15 and the anti-reflection coating 14 has to be avoided. In a second sub-step, a rim of the conductive back coating 15 is removed. The removal of that rim of the conductive back coating 15 can be done by chemical etching and/or lift-off of the rim and/or laser ablation.

Fig. 6 schematically shows the structure of Fig. 5 after removal of the mask 16.

As schematically shown in Fig. 7, the method of manufacturing a hetero-junction solar cell 1 in according with the present invention ends with forming a front grid metallization 21. In some cases, in an additional step, a back electrode 22 is formed by a metallization of the back side of the conductive back coating 15.

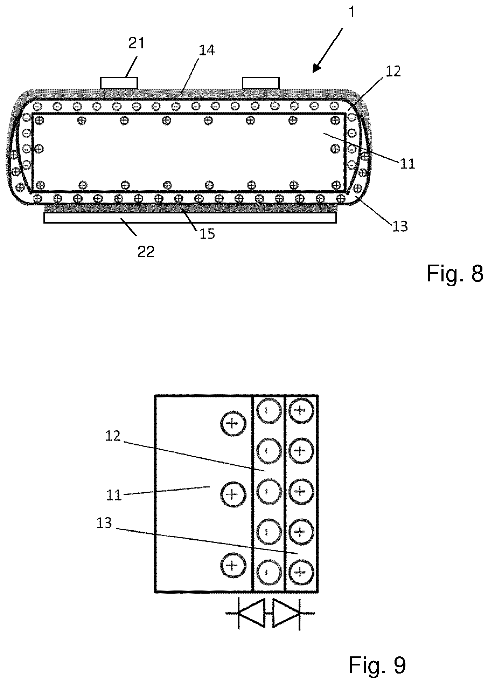

Fig. 8 corresponds to Fig. 7 with added charges illustrating the charge distribution at the front side, on the back side and on the edge 19 of the hetero-junction solar cell 1, wherein in the example shown the semiconductor substrate 11 is n-doped, the at least one front layer 12 is p-doped and the at least one back layer 13 is n-doped.

Fig. 9 schematically shows the stack of layers 11, 12, 13 present on the edge 19 of the hetero-junction solar cell 1 of Fig 8. The horizontal structure n/(i)p/(i)n provided by the n-doped semiconductor substrate 11, the p-doped at least one front layer 12 (emitter) and the n-doped at least one back layer 13 (back surface field) acts as two diodes in opposition blocking a current flow in lateral direction. If the at least one back layer 13 would be formed prior to forming of the at least one front layer 12, that would lead to a shunt.

## Claims

1. Method of manufacturing a hetero-junction solar cell (1), the solar cell (1) comprising a front side for an incidence of light into the solar cell (1) and a back side opposite to the front side, the method including the steps of
- providing a doped and textured semiconductor substrate (11), said semiconductor substrate (11) having a front surface (17) and a back surface (18) opposite to each other and an edge (19) surrounding the semiconductor substrate (11);
- forming at least one front layer (12) on the front surface (17) of the semiconductor substrate (11), wherein the at least one front layer (12) covers at least a part of the edge (19) of the semiconductor substrate (11), said at least one front layer (12) containing semiconductor atoms or molecules being arranged in amorphous and/or microcrystalline and/or oxide and/or carbide phase, wherein said at least one front layer (12) forms an emitter or a front surface field of the solar cell (1);
- forming at least one back layer (13) on the back surface (18) of the semiconductor substrate (11), said at least one back layer (13) containing semiconductor atoms or molecules being arranged in amorphous and/or microcrystalline and/or oxide and/or carbide phase, wherein said at least one back layer (13) forms a back surface field or a back emitter of the solar cell (1), and wherein the at least one front layer (12) is formed prior to forming of the at least one back layer (13), and the at least one back layer (13) covers at least a part of the edge of the semiconductor substrate (11) and also covers at least a part of the at least one front layer (12) that overlaps the edge of the semiconductor substrate (11);
- forming an electrically conductive anti-reflection coating (14) on the at least one front layer (12), said anti-reflection coating (14) being at least partially transparent to the light irradiating into the solar cell (1), wherein the anti-reflection coating (14) covers at least a part of the at least one back layer (13) overlapping the edge (19);
- forming an electrically conductive back coating (15) on the at least one back layer (13); and
- forming a front grid metallization (21) on the anti-reflection coating (14);
wherein the conductive back coating (15) is formed on the surface of the at least one back layer (13) with a distance to the edge (19) of the semiconductor substrate (11), leaving a margin area of the surface of the at least one back layer (13) and the edge (19) of the semiconductor substrate (11) free from the conductive back coating (15), wherein there is no electrical contact between the conductive back coating (15) and the conductive anti-reflection coating (14) at all during the whole process of formation of the conductive back coating (15),
wherein said electrically conductive anti-reflection coating (14) covers the whole surface of the at least one front layer (12), **characterized in that** the electrically conductive anti-reflection coating (14) covers at least a part of the edge (19) of the semiconductor substrate (11).

2. Method of claim 1, wherein the conductive back coating (15) is formed with a distance of 5 µm to 10 mm from the edge (19) of the semiconductor substrate (11).

3. Method of claim 2, wherein the conductive back coating (15) is formed with a distance of 30 µm to 3 mm from the edge (19) of the semiconductor substrate (11).

4. Method of at least one of the preceding claims, wherein the conductive back coating (15) is deposited on the surface of the at least one back layer (13) through a shadow mask (16) having a opening (20) being adapted to the dimensions of the semiconductor substrate (11), but smaller, and having a cover region around this opening (20) covering at least the margin area of the surface of the at least one back layer (13) during deposition.

5. Method of at least one of the claims 1 to 3, wherein the conductive back coating (15) is deposited on the whole surface of the at least one back layer (13), followed by a removal of a rim of the conductive back coating (15).

6. Method of claim 5, wherein the removal of the rim of the conductive back coating (15) is done by chemical etching and/or lift-off and/or laser ablation of the rim of the conductive back coating (15).

## Patentansprüche

1. Verfahren zum Herstellen einer Solarzelle (1) mit Hetero-Übergang, wobei die Solarzelle (1) eine Vorderseite für einen Lichteinfall in die Solarzelle (1) und eine der Vorderseite gegenüberliegende Rückseite aufweist, wobei das Verfahren die folgenden Schritte umfasst:
- Bereitstellen eines dotierten und texturierten Halbleitersubstrats (11), wobei das Halbleitersubstrat (11) eine Vorderseitenoberfläche (17) und eine Rückseitenoberfläche (18), die einander gegenüberliegen, und eine Kante (19), die das Halbleitersubstrat (11) umgibt, aufweist;
- Ausbilden wenigstens einer Vorderseitenschicht (12) auf der Vorderseitenoberfläche (17) des Halbleitersubstrats (11), wobei die wenigstens eine Vorderseitenschicht (12) wenigstens einen Teil des Randes (19) des Halbleitersubstrats (11) bedeckt, wobei die wenigstens eine Vorderseitenschicht (12) Halbleiteratome oder -moleküle enthält, die in amorpher und/oder mikrokristalliner und/oder Oxid- und/oder Karbidphase angeordnet sind, wobei die wenigstens eine Vorderseitenschicht (12) einen Emitter oder ein Vorderseitenoberflächenfeld der Solarzelle (1) ausbildet;
- Ausbilden wenigstens einer Rückseitenschicht (13) auf der Rückseitenoberfläche (18) des Halbleitersubstrats (11), wobei die wenigstens eine Rückseitenschicht (13) Halbleiteratome oder -moleküle enthält, die in amorpher und/oder mikrokristalliner und/oder Oxid- und/oder Karbidphase angeordnet sind, wobei die wenigstens eine Rückseitenschicht (13) ein Rückseitenoberflächenfeld oder einen Rückseitenemitter der Solarzelle (1) ausbildet, und wobei die wenigstens eine Vorderseitenschicht (12) vor dem Ausbilden der wenigstens einen Rückseitenschicht (13) ausgebildet wird und die wenigstens eine Rückseitenschicht (13) wenigstens einen Teil der Kante des Halbleitersubstrats (11) bedeckt und auch wenigstens einen Teil der wenigstens einen Vorderseitenschicht (12) bedeckt, der die Kante des Halbleitersubstrats (11) überlappt;
- Ausbilden einer elektrisch leitfähigen Antireflexionsbeschichtung (14) auf der wenigstens einen Vorderseitenschicht (12), wobei die Antireflexionsbeschichtung (14) für das in die Solarzelle (1) einfallende Licht wenigstens teilweise transparent ist, wobei die Antireflexionsbeschichtung (14) wenigstens einen Teil der wenigstens einen Rückseitenschicht (13) bedeckt, der die Kante (19) überlappt;
- Ausbilden einer elektrisch leitfähigen Rückseitenbeschichtung (15) auf der wenigstens einen Rückseitenschicht (13); und
- Ausbilden einer Vorderseiten-Gittermetallisierung (21) auf der Antireflexionsbeschichtung (14);
wobei die leitfähige Rückseitenbeschichtung (15) auf der Oberfläche der wenigstens einen Rückseitenschicht (13) mit einem Abstand zur Kante (19) des Halbleitersubstrats (11) ausgebildet wird, sodass ein Randbereich der Oberfläche der wenigstens einen Rückseitenschicht (13) und der Kante (19) des Halbleitersubstrats (11) von der leitfähigen Rückseitenbeschichtung (15) frei bleibt,
wobei während des gesamten Prozesses der Ausbildung der leitfähigen Rückseitenbeschichtung (15) überhaupt kein elektrischer Kontakt zwischen der leitfähigen Rückseitenbeschichtung (15) und der leitfähigen Antireflexionsbeschichtung (14) besteht,
wobei die elektrisch leitfähige Antireflexionsbeschichtung (14) die gesamte Oberfläche der wenigstens einen Vorderseitenschicht (12) bedeckt,
**dadurch gekennzeichnet, dass** die elektrisch leitfähige Antireflexionsbeschichtung (14) wenigstens einen Teil der Kante (19) des Halbleitersubstrats (11) bedeckt.

2. Verfahren nach Anspruch 1, wobei die leitfähige Rückseitenbeschichtung (15) in einem Abstand von 5 µm bis 10 mm von der Kante (19) des Halbleitersubstrats (11) ausgebildet wird.

3. Verfahren nach Anspruch 2, wobei die leitfähige Rückseitenbeschichtung (15) in einem Abstand von 30 µm bis 3 mm von der Kante (19) des Halbleitersubstrats (11) ausgebildet wird.

4. Verfahren nach wenigstens einem der vorhergehenden Ansprüche, wobei die leitfähige Rückseitenbeschichtung (15) auf der Oberfläche der wenigstens einen Rückseitenschicht (13) durch eine Lochmaske (16) abgeschieden wird, die eine Öffnung (20), die an die Abmessungen des Halbleitersubstrats (11) angepasst, aber kleiner ist, und einen Abdeckbereich um diese Öffnung (20) herum, der während der Abscheidung wenigstens den Randbereich der Oberfläche der wenigstens einen Rückseitenschicht (13) bedeckt, aufweist.

5. Verfahren nach wenigstens einem der Ansprüche 1 bis 3, wobei die leitfähige Rückseitenbeschichtung (15) auf der gesamten Oberfläche der wenigstens einen Rückseitenschicht (13) abgeschieden wird, wonach ein Rand der leitfähigen Rückseitenbeschichtung (15) entfernt wird.

6. Verfahren nach Anspruch 5, wobei das Entfernen des Randes der leitfähigen Rückseitenbeschichtung (15) durch chemisches Ätzen und/oder Abheben und/oder Laserablation des Randes der leitfähigen Rückseitenbeschichtung (15) erfolgt.

## Revendications

1. Procédé de fabrication d'une cellule solaire (1) à hétérojonction, la cellule solaire (1) comprenant un côté avant pour une incidence de lumière dans la cellule solaire (1) et un côté arrière opposé au côté avant, le procédé comportant les étapes consistant à
- fournir un substrat semi-conducteur (11) dopé et texturé, ledit substrat semi-conducteur (11) ayant une surface avant (17) et une surface arrière (18) opposées l'une à l'autre et une bordure (19) entourant le substrat semi-conducteur (11) ;
- former au moins une couche avant (12) sur la surface avant (17) du substrat semi-conducteur (11), l'au moins une couche avant (12) couvrant au moins une partie du bord (19) du substrat semi-conducteur (11), ladite au moins une couche avant (12) contenant des atomes ou molécules semi-conducteurs étant agencés en phase amorphe et/ou microcristalline et/ou oxyde et/ou carbure, ladite au moins une couche avant (12) formant un émetteur ou un champ de surface avant de la cellule solaire (1) ;
- former au moins une couche arrière (13) sur la surface arrière (18) du substrat semi-conducteur (11), ladite au moins une couche arrière (13) contenant des atomes ou molécules semi-conducteurs étant agencés en phase amorphe et/ou microcristalline et/ou oxyde et/ou carbure, ladite au moins une couche arrière (13) formant un champ de surface arrière ou un émetteur arrière de la cellule solaire (1), et l'au moins une couche avant (12) étant formée avant la formation de l'au moins une couche arrière (13), et l'au moins une couche arrière (13) couvrant au moins une partie de la bordure du substrat semi-conducteur (11) et couvrant également au moins une partie de l'au moins une couche avant (12) qui chevauche la bordure du substrat semi-conducteur (11) ;
- former un revêtement antireflet (14) électriquement conducteur sur l'au moins une couche avant (12), ledit revêtement antireflet (14) étant au moins partiellement transparent à la lumière irradiant dans la cellule solaire (1), le revêtement antireflet (14) couvrant au moins une partie de l'au moins une couche arrière (13) chevauchant la bordure (19) ;
- former un revêtement arrière (15) électriquement conducteur sur l'au moins une couche arrière (13) ; et
- former une métallisation à grille avant (21) sur le revêtement antireflet (14) ;
le revêtement arrière (15) conducteur étant formé sur la surface de l'au moins une couche arrière (13) avec une distance jusqu'à la bordure (19) du substrat semi-conducteur (11), en laissant une zone de bordure de la surface de l'au moins une couche arrière (13) et la bordure (19) du substrat semi-conducteur (11) exempt du revêtement arrière (15) conducteur,
il n'y avant absolument aucun contact électrique entre le revêtement arrière (15) conducteur et le revêtement antireflet (14) conducteur pendant l'entièreté du processus de formation du revêtement arrière (15) conducteur,
ledit revêtement antireflet (14) électriquement conducteur couvrant l'entièreté de la surface de l'au moins une couche avant (12), **caractérisé en ce que** le revêtement antireflet (14) électriquement conducteur couvre au moins une partie de la bordure (19) du substrat semi-conducteur (11).

2. Procédé selon la revendication 1, le revêtement arrière (15) conducteur étant formé avec une distance de 5 µm à 10 mm à partir de la bordure (19) du substrat semi-conducteur (11).

3. Procédé selon la revendication 2, le revêtement arrière (15) conducteur étant formé avec une distance de 30 µm à 3 mm à partir de la bordure (19) du substrat semi-conducteur (11).

4. Procédé selon au moins l'une des revendications précédentes, le revêtement arrière (15) conducteur étant déposé sur la surface de l'au moins une couche arrière (13) par l'intermédiaire d'un masque perforé (16) ayant une ouverture (20) étant adapté aux dimensions du substrat semi-conducteur (11), mais plus petit, et ayant une région de couverture autour de cette ouverture (20) couvrant au moins la zone de bordure de la surface de l'au moins une couche arrière (13) pendant le dépôt.

5. Procédé selon au moins l'une des revendications 1 à 3, le revêtement arrière (15) conducteur étant déposé sur l'entièreté de la surface de l'au moins une couche arrière (13), suivi par un retrait d'un rebord du revêtement arrière (15) conducteur.

6. Procédé selon la revendication 5, le retrait du rebord du revêtement arrière (15) conducteur étant réalisé par décapage chimique et/ou décollage et/ou ablation au laser du rebord du revêtement arrière (15) conducteur.
